Europäisches Patentamt

**European Patent Office**

**Office européen des brevets**

(19)

(11) Numéro de publication: **0 333 070**
**A2**

## (12) DEMANDE DE BREVET EUROPEEN

(21) Numéro de dépôt: **89104298.8**

(51) Int. Cl.⁴: **H03M 1/34**

(22) Date de dépôt: **10.03.89**

(30) Priorité: **16.03.88 CH 984/88**

(43) Date de publication de la demande:
**20.09.89 Bulletin 89/38**

(84) Etats contractants désignés:
**AT BE CH DE ES FR GB GR IT LI LU NL SE**

(71) Demandeur: **TECNOSPACE S.A.**
**36, rue de Montchoisy**
**CH-1207 Genève(CH)**

(72) Inventeur: **Fletcher, Eric**
**Sous-Cor**
**CH-1252 Eysins(CH)**

(74) Mandataire: **Micheli & Cie**
**118, rue du Rhône Case postale 47**
**CH-1211 Genève 6(CH)**

(54) **Procédé de numérisation de la valeur d'un angle défini par ses coordonnées trigonométriques sinus et cosinus.**

(57) Selon ce procédé :

a. on procède à un échantillonnage de la valeur des deux signaux trigonométriques aux sommets d'une fréquence porteuse,

b. on détermine à partir de ces signaux l'angle correspondant par une conversion analogique-numérique par approximations successives,

c. lors d'une première phase de la conversion on détermine les deux premiers bits de cet angle numérisé par la détection des polarités du signal sinus et du signal cosinus,

d. lors d'une seconde phase de cette conversion on détermine le troisième bit de cet angle numérisé par comparaison des valeurs absolues des signaux sinus et cosinus,

e. on utilise la plus grande valeur de cette comparaison comme référence du convertisseur digital-numérique et la plus petite valeur de cette comparaison comme signal d'entrée de ce convertisseur,

f. on détermine à l'aide du troisième bit binaire de l'angle numérisé la fonction non linéaire, tangente ou cotangente, utilisée en rétroaction pour la détermination des quatrièmes à énièmes bits,

g. on transforme les trois premiers bits binaires purs obtenus par les première et seconde phases de comparaison en code Gray avec inversion du bit de plus grand poids à chaque demi-période de la fréquence porteuse,

h. on détermine, à l'aide des trois premiers bits binaires purs de la conversion de l'angle numérisé après les avoir transformés en code Gray, l'octant de l'angle à déterminer,

i. lors d'une troisième phase de la conversion on détermine les quatrièmes à énièmes bits de l'angle numérisé à mesurer par une conversion non linéaire pondérée par la fonction trigonométrique définie par le troisième bit de la conversion,

j. on génère en fonction des sommets positifs ou négatifs de la fréquence porteuse les mots binaires, (tous 0) ou (tous 1), nécessaires dans les deux premières phases de conversion pour la détermination de la polarité des bits et dans la troisième phase de la conversion pour la détermination de la fonction trigonométrique utilisée.

EP 0 333 070 A2

## PROCEDE DE NUMERISATION DE LA VALEUR D'UN ANGLE DEFINI PAR SES COORDONNEES TRIGONO-METRIQUES SINUS ET COSINUS

Dans de nombreuses applications, il est nécessaire de déterminer numériquement la valeur d'un angle mesurée par les coordonnées trigonométriques, sinus et cosinus, de cet angle afin de pouvoir utiliser ces données dans des centres de calculs ou de commandes des éléments mécaniques dont l'angle est mesuré. Ceci est particulièrement vrai en robotique et dans cette application le nombre d'axes dont la position angulaire doit être mesurée et commandée peut dépasser la dizaine. Or les convertisseurs analogiques-numériques actuels sont trop lents et ne peuvent pas être multiplexés de sorte que pour chaque axe, ou angle à mesurer, une chaîne de traitement complète de l'information doit être prévue, ce qui renchérit énormément les installations robotisées.

La présente invention a pour objet un procédé de numérisation de la valeur d'un angle défini par ses coordonnées trigonométriques sinus et cosinus, ainsi qu'un dispositif pour sa mise en oeuvre, qui obvie aux inconvénients précités des dispositif existants tout en ayant une résolution supérieure à ceux-ci.

Le présent procédé et le présent dispositif se distinguent par les caractéristiques décrites et revendiquées dans ce qui suit, prises séparément ou en combinaison.

Le dessin annexé illustre schématiquement et à titre d'exemple une forme d'exécution du procédé et du dispositif selon l'invention.

La figure 1 est une représentation schématique de résolveur.

La figure 2 est une représentation des formes d'ondes des signaux émis par le résolveur dans les différents quadrants I à VIII.

La figure 3 illustre pour chaque quadrant I à VIII les signes et les valeurs relatives absolues des signaux émis par le résolveur.

La figure 4 est un schéma bloc d'un convertisseur analogique-numérique par approximation successives.

La figure 5 schématise l'échantillonnage et le blocage des signaux émis par le résolveur.

La figure 6 illustre le schéma d'un convertisseur numérique-analogique multiplicateur à double entrées.

La figure 7 illustre la boucle de conversion selon la présente invention.

La figure 8 illustre un diagramme de commutation de gains et de décodage des octants.

La figure 9 illustre la séquence des décisions des trois bits de plus grand poids du convertisseur analogique-numérique à approximations successives.

La figure 10 illustre schématiquement un convertisseur de code binaire pur en code Gray.

Le procédé selon la présente invention de numérisation de la valeur d'un angle, par exemple d'un arbre rotatif, défini par ses coordonnées trigonométriques sinus et cosinus, suppose que l'on dispose à tout instant, par un capteur adéquat qui peut être un inductosyn (marque déposée) ou un résolveur par exemple, de la valeur instantanée du sinus et du cosinus correspondant à la position angulaire de l'arbre rotatif que l'on veut numériser. Pour ce faire tout type de capteur donnant la position angulaire de l'organe rotatif par ses coordonnées trigonométriques sinus et cosinus est utilisable.

Pour simplifier et rendre plus concrète la description du présent procédé de conversion et son dispositif de mise en oeuvre on supposera dans ce qui suit, sans préjudice de l'utilisation d'autres capteurs d'angles, que ce capteur est un résolveur sans balais de type émetteur constituant un capteur inductif de position angulaire. Un tel résolveur comporte un stator et un rotor, le stator étant muni au primaire d'un transformateur rotatif dont le secondaire se trouve sur le rotor et alimente un enroulement de mesure induisant dans des enroulements de mesure statorique décalés de 90° et de nombre de spires égaux, des signaux en quadrature représentatifs du sinus et du cosinus de la position angulaire du rotor par rapport au stator. En effet l'enroulement de mesure du rotor induit dans les enroulements de mesures statoriques des tensions sinusoïdales monophasées d'une fréquence correspondant à celle de l'excitation du primaire du transformateur rotatif et dont les amplitudes respectives sont modulées par les coordonnées trigonométriques sinus et cosinus de l'angle du rotor par rapport au stator.

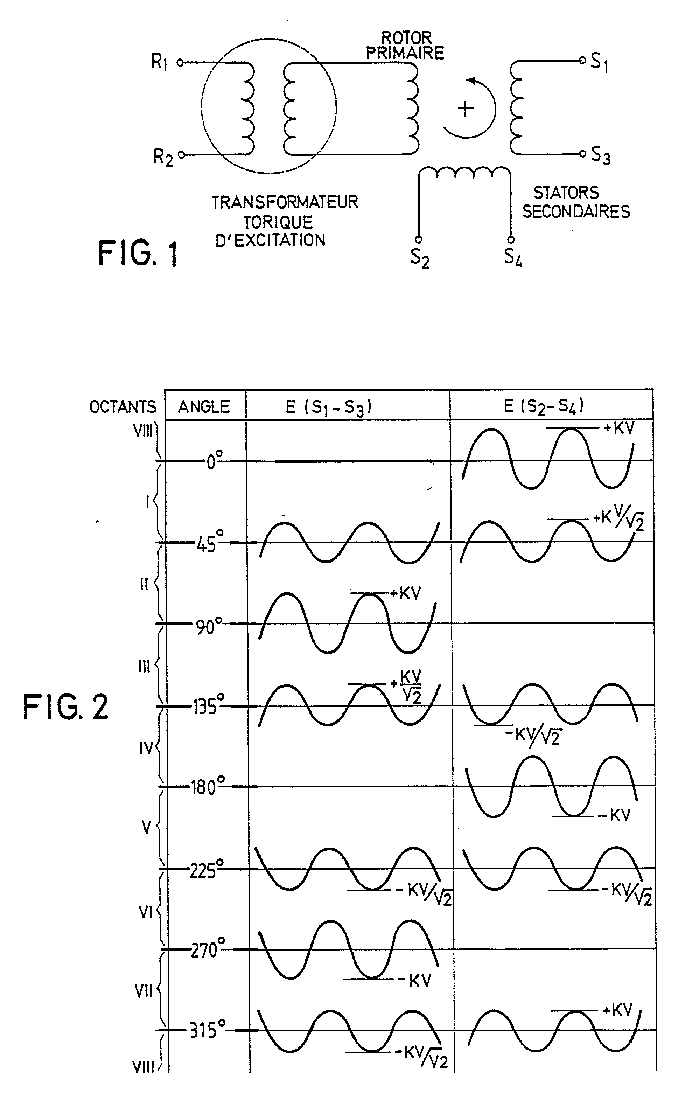

Un tel résolveur peut être schématiquement illustré comme à la figure 1 et si R1, R2 sont les bornes du primaire du transformateur rotatif ; S1,S3 et S2,S4 les bornes des enroulements statoriques de mesure et de plus que le sens positif de l'angle de rotation $\theta$ du rotor par rapport au stator est le sens trigonométrique, contraire aux aiguilles d'une montre, les équations de fonctionnement du résolveur sont :

$$E (S1-S3) = K.E. (R1-R2) \sin \theta$$
$$E (S2-S4) = K.E. (R1-R2) \cos \theta$$

K étant le rapport de transformation entre les stators et le rotor.

La tension d'excitation E (R1-R2) est de la forme $v\sin 2\pi$ ft ou t est la variable temporelle et f la fréquence d'excitation qui peut se situer de préférence entre 400 Hz et 10 KHz. La figure 2 illustre les formes d'ondes de E (S1-S3) et E (S2-S4) pour un résolveur parfait pour des angles entre rotor et stator de $0°, 45°, 90°, 135°, 180°, 225°, 270°$ et $315°$ définissant huit octants I à VIII pour une révolution complète de $360°$.

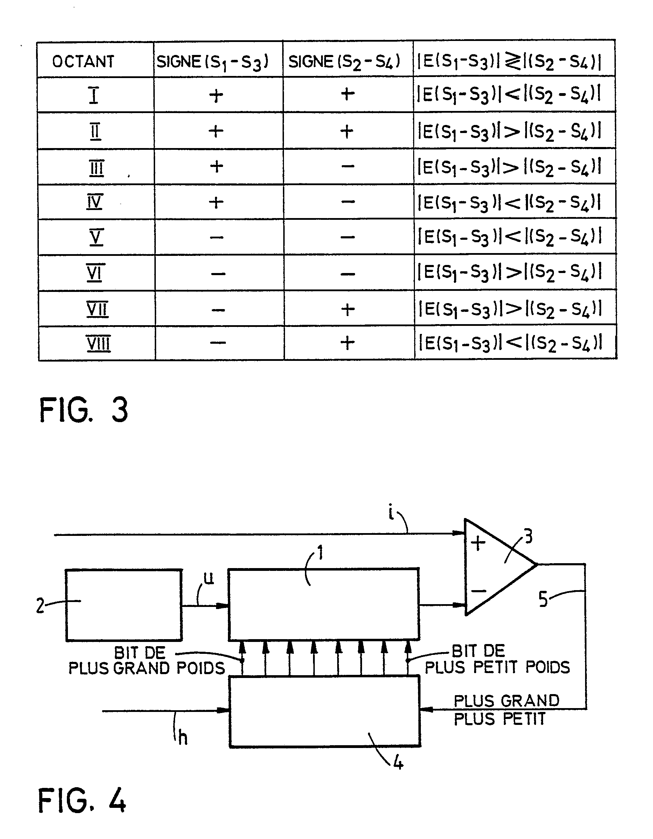

La reconnaissance de l'octant dans lequel est placé le rotor par rapport au stator se fait par comparaison des signes + ou - des signaux E (S1-S3) et E (S2-S4), respectivement des phases relatives des ces signaux par rapport à la tension d'excitation E (R1-R2) et par la connaissance des amplitudes relatives de ces deux mêmes signaux E (S1-S3) et E (S2-S4). Cette reconnaissance de l'octant I à VIII dans lequel se trouve le rotor du résolveur par rapport à son stator est illustré au tableau de la figure 3, en admettant par définition le signe + pour un signal induit en phase avec la tension d'excitation et un signe - pour un signal induit en opposition de phase avec la tension d'excitation du résolveur. A l'intérieur de chacun des octants I à VIII la détermination précise de l'angle du rotor par rapport au stator s'effectue par un calcul trigonométrique à partir du rapport des amplitudes des valeurs absolues des signaux induits E (S1-S3) et E (S2-S4).

Un tel résolveur, de même que de nombreux autres capteurs angulaires pouvant être utilisés, détermine de manière univoque à l'intérieur d'une révolution complète un angle à partir de ses coordonnées trigonométriques en sinus et cosinus.

Une fois connue la valeur en degrés de l'angle du rotor par rapport au stator celle-ci doit, pour pouvoir être traitée aisément, rapidement et avec précision par des calculatrices, être numérisée.

Pour cette conversion analogique-numérique on utilise l'une des trois méthodes bien connues, celle par approximations successives qui pour cette application est particulièrement avantageuse du fait du faible temps de conversion, quelques micro-secondes à quelques centaines de micro-secondes, et surtout du fait que pour une résolution donnée le temps de conversion est identique quelle que soit l'amplitude du signal à numériser. Cette propriété de ce type de convertisseur permet un multiplexage d'un nombre élevé de canaux ce que d'autres ne permettent pas.

Le principe de basé d'un tel convertisseur analogique-numérique par approximations successives est analogue à la détermination d'un poids inconnu avec une balance à plateau et un nombre de poids étalonnés donné.

Ce convertisseur analogique-numérique illustré à la figure 4 est constitué par un convertisseur numérique-analogique 1 alimenté par une tension de référence u délivrée par un générateur de tension stabilisée 2. La sortie de ce convertisseur 1 alimente l'une des entrées d'un comparateur 3 dont l'autre entrée est alimentée par la tension inconnue à numériser i. La sortie s de ce comparateur, indiquant si la tension inconnue i est plus grande ou plus petite en valeur absolue que la tension délivrée par le convertisseur numérique-analogique 1. Cette tension s de sortie du comparateur 3 alimente un registre d'approximations successives 4 piloté par un signal d'horloge h.

Ainsi le convertisseur analogique-numérique (fig.4) reçoit une tension analogique inconnue i et le compare au produit d'une tension de référence u pondérée par des combinaisons binaires des fractions 1/2, 1/4, 1/8, ... $1/2^N$ de cette tension de référence u, pondération assurée par le convertisseur numérique-analogique 1 à l'aide des sorties du registre d'approximations successives 4 qui effectue successivement les N séquences :

$$
\begin{array}{ccccccccc}
0 & 1 & 1 & 1 & 1 & 1 & 1 & 1 & 1 \\
B0 & 0 & 1 & 1 & 1 & 1 & 1 & 1 & 1 \\
B0 & B1 & 0 & 1 & 1 & 1 & 1 & 1 & 1 \\
\cdots\cdots\cdots\cdots\cdots\cdots\cdots\cdots\cdots \\
B0 & B1 & B2 & \cdots\cdots\cdots\cdots\cdots\cdots\cdots Bn
\end{array}
\qquad N\ \text{séquences}
$$

N bits

jusqu'à ce que tous les bits soient déterminés par le comparateur 3. Le fonctionnement du registre d'approximations successives 4 est piloté par un signal d'horloge h dont la période est plus grande que la somme des temps d'établissement de travail du convertisseur numérique-analogique 1 et de décision du comparateur 3. Lorsque le dernier bit Bn est déterminé le contenu du registre d'approximations successives représente la numérisation de la tension inconnue i.

Le fonctionnement de ce convertisseur analogique-numérique (fig.4) présuppose que les tensions inconnues i et de référence u restent stables pendant tout le cycle de conversion.

Comme dans le cas qui nous occupe les tensions de référence et inconnues sont les signaux délivrés par le résolveur, c'est-à-dire des signaux constitués par une fréquence porteuse sinusoïdale modulée par la position angulaire du rotor du résolveur par rapport à son stator on procède à un échantillonnage de ces signaux suffisamment étendu pour les analyser puis à une mémorisation temporaire de ces échantillons le temps que la conversion soit effectuée.

Après avoir succinctement décrit un codeur d'angle sous forme de résolveur et un convertisseur analogique-numérique par approximations successives, pour permettre une meilleure compréhension de l'objet de l'invention, soit la numérisation de la position angulaire d'un organe tournant à partir de signaux trigonométriques représentatifs de cette position angulaire, celui-ci va être maintenant abordé en détail.

On notera tout d'abord deux particularités importantes du signal délivré par un résolveur pour sa numérisation par un convertisseur analogique-numérique qui sont que :

a. le signal est double, représenté par deux coordonnées trigonométriques, sinus et consinus, dont le rapport est ratiométrique, c'est-à-dire indépendant de la valeur de la tension rotorique E(R1-R2) qui n'a donc pas besoin d'être très stable en amplitude,

b. le signal est modulé en amplitude avec suppression de la porteuse, il présente donc des passages par zéro et par des crêtes alternativement positives et négatives à chaque demi-période de la fréquence porteuse,

Du fait que le convertisseur analogique-numérique par approximations successives fonctionne à partir de tensions continues stables, on échantillonne les signaux du résolveur et bloque ses valeurs correspondante aux crêtes de tensions E(S1-S3) et E(S2-S4), appelées respectivement sinus et cosinus.

Pour commander le blocage du circuit d'échantillonnage exactement sur les crêtes des signaux du résolveur on peut utiliser différentes méthodes telles que :

a. la génération de la tension rotorique E(R1-R2) par une division digitale à partir d'une horloge à quartz de haute fréquence pour obtenir deux ondes en créneau en quadrature, l'une produisant par filtrage un sinus et l'autre commandant les échantillonnages,

b. l'utilisation d'un oscillateur en quadrature de la tension rotorique E(R1-R2) et la détection à l'aide d'un comparateur des passages par zéro.

Le fait d'acquérir à chaque demi-période de la porteuse une valeur relevante offre l'avantage de pouvoir doubler la cadence de l'échantillonage. Il faut noter que les échantillons relatifs à la seconde demi-période (SIN 270° et COS 270°) sont en opposition de phase avec ceux pris lors de la première demi-période (SIN 90° et COS 90°).

L'utilisation d'un convertisseur analogique-numérique par approximations successives pour la numérisation de la valeur d'un angle défini par les signaux délivrés par un résolveur nécessite un traitement particulier des trois premiers bits, les trois bits de plus grand poids, de la séquence de conversion du fait que les échantillons SIN et COS sont alternativement positifs et négatifs et aussi alternativement plus grands ou plus petits en valeur relative suivant les octants I à VIII.

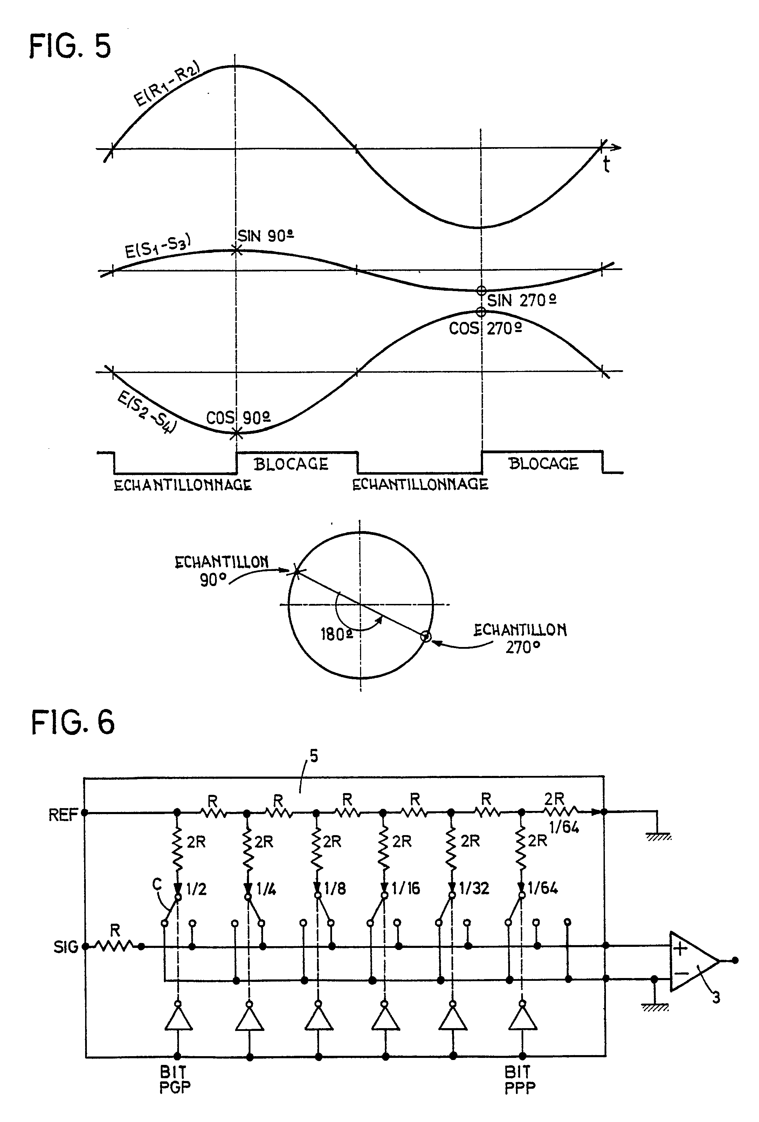

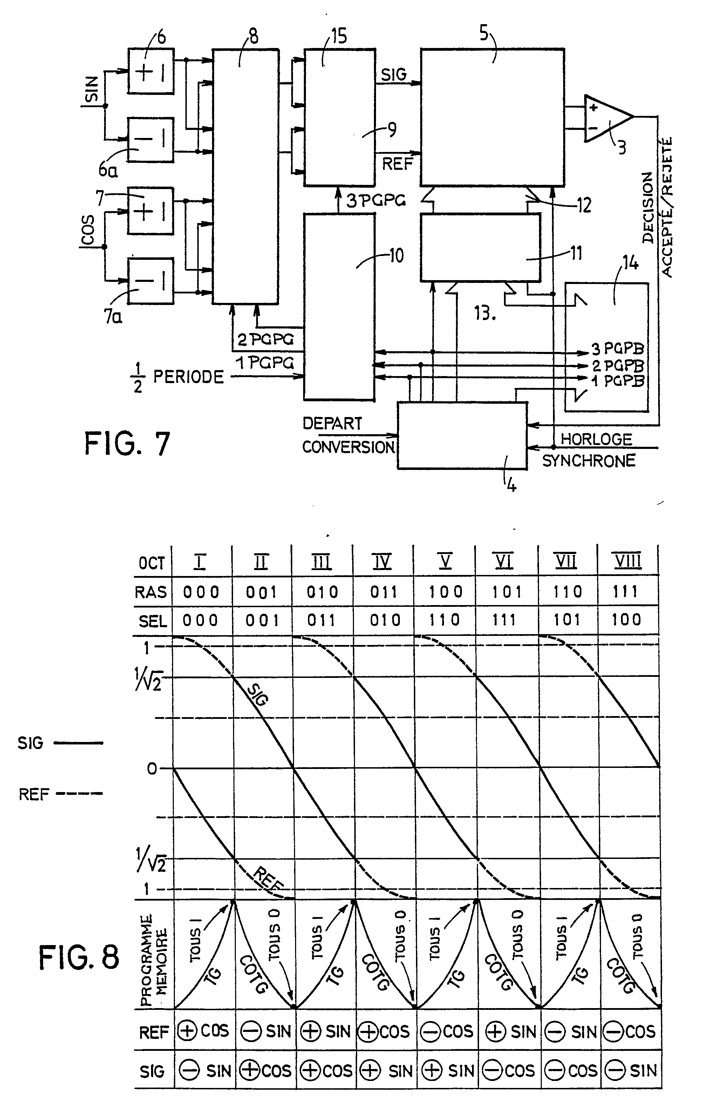

La figure 6 illustre le diagramme d'échantillonnage et la figure 7 un schéma d'un convertisseur numérique-analogique multiplicateur à double entrée 5 utilisé pour résoudre le problème lié à la particularité de l'échantillonnage. Dans cet ensemble, il s'agit d'un convertisseur numérique-analogique de technologie CMOS à deux entrées SIG et REF d'un modèle à six bits.

La première de ces entrées SIG est reliée directement à la sortie à travers une résistance R de 10 KΩ. La second entrée REF accède à un réseau de résistances de même valeur nominale R = 10 KΩ organisées en échelles diviseuses binaires (R-2 R) et ce réseau est commandé digitalement au travers de commutateurs analogiques C pour les sorties digitales du registre d'approximations successives 4.

Le convertisseur numérique-analogique multiplicateur à double entrée 5 est intégré dans la boucle de conversion illustrée à la figure 7. Le registre d'approximations successives 4 est réalisé à partir de circuits intégrés modulaires d'une longueur de 8 ou 12 bits pouvant être montés en cascade ou tronqués pour obtenir un registre de longueur désirée, en particulier 12, 14 ou 16 bits.

Le convertisseur analogique-numérique illustré à la figure 7 comporte des amplificateurs 6,6a et 7,7a de gain +1 et -1 respectivement alimentés par les signaux SIN et COS respectivement et alimentant un multiplexeur différentiel à quatre canaux 8. Il comporte encore un double contacteur à deux contacts 9 délivrant les signaux SIG et REF ; un sélecteur 10 binaire/Gray à trois bits alimenté d'une part par les trois premiers bits de plus grand poids du registre d'approximations successives 4 et par un signal demi-période de la fréquence porteuse. Ce sélecteur 10 alimente le multiplexeur 8 ainsi que le double commutateur 9. Une mémoire morte (PROM) 11 mémorise les fonctions tangente et cotangente, elle est reliée par un bus 12 au convertisseur numérique-analogique multiplicateur à double chargement 5. Un bus 13 relie le registre d'approximations successives 4 à la mémoire PROM 11 ainsi qu'à un circuit de sortie 14 délivrant la valeur de l'angle numérisée. La totalité de cette mémoire PROM n'est complètement utilisée qu'à partir du troisième bit de plus grand poids du registre d'approximations successives 4.

La numérisation des signaux SIN et COS, représentatifs de la valeur angulaire mesurée, résultant de l'échantillonnage et du blocage des signaux délivrés par le résolveur nécessite trois phases.

Dans une première phase on détermine la polarité des signaux SIN et COS qui seront utilisés dans la suite de la conversion. Pour ce faire, les sorties SIN et COS des circuits échantillonneurs-bloqueurs alimentent des amplificateurs 6,6a ; 7,7a respectivement de gains +1 et -1 désignant les signaux +SIN, -SIN ; +COS, -COS sur les entrées du double multiplexeur différentiel à quatre canaux 8.

Lorsque le troisième bit de plus grand poids du registre d'approximations successives 4 est à l'état 0 c'est que l'on se trouve dans un octant impair I,III,V,VII (fig.8), les bits au-delà du troisième du registre d'approximations successives 4 sont pondérés par la mémoire PROM 11 par la fonction digitale tg $\frac{\pi}{4}$ X. Quand par contre le troisième bit de plus grand poids du registre d'approximations successives 4 est à l'état I c'est que l'on se trouve dans un octant pair (fig.8), les bits au-delà du troisième registre d'approximations successives 4 sont pondérés par la fonction digitale cotg $\frac{\pi}{4}$ (X+1). Ces deux fonctions digitales sont mémorisées dans la mémoire PROM 11. Les deux fonctions tg $\frac{\pi}{4}$ X et cotg $\frac{\pi}{4}$ (X+1) sont mémorisées symétriquement par rapport aux angles de 45°,135°,225° et 315° dans chaque quadrant. Dans les octants impairs la fonction tg $\frac{\pi}{4}$ X débute par un bit de plus petit poids au dessus de zéro à l'adresse tous 0 pour s'achever tous pour l'adresse tous 1. Dans les octants pairs, la fonction cotg $\frac{\pi}{4}$ (X+1) débute par un bit de plus petit poids au dessous de 1 pour l'adresse tous 0 et s'achève à un mot tous 0 pour l'adresse tous 1.

Les deux premiers bits de plus grand poids du registre d'approximations successives 4 déterminent la polarité des signaux SIN et COS. Si l'on attribue l'état 0 à la polarité positive et l'état I à la polarité négative on constate que ceci équivaut à déterminer les deux premiers bits de plus grand poids du registre d'approximations successives 4 en code Gray.

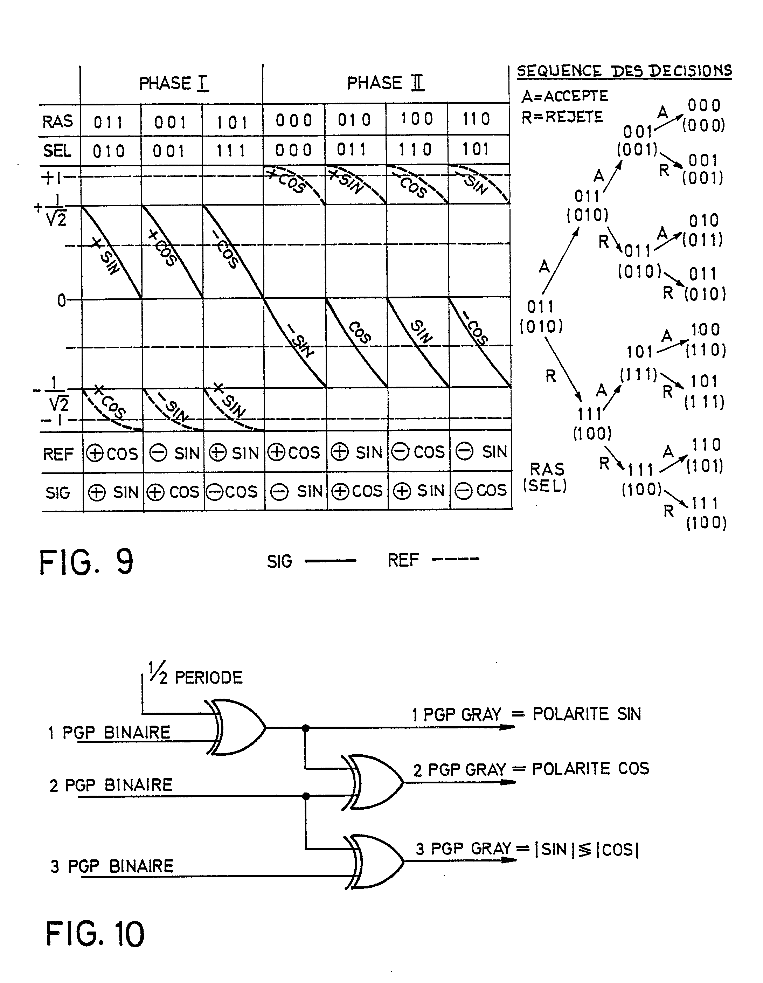

La figure 10 est le schéma d'un transcodeur binaire pur -Gray qui comporte un assemblage de trois portes OU-EXCLUSIF. Le bit de demi-période appliqué à l'une des entrées de la première porte OU-EXCLUSIF dont l'autre entrée reçoit le bit de plus grand poids du registre d'approximations successives 4 corrige le déphasage de 180° des signaux de sortie sur les échantillons pris sur les crêtes négatives de E-(S1-S2) et E(S2-S4).

La seconde porte OU-EXCLUSIVE est alimentée par la sortie de la première porte et par le bit de deuxième plus grand poids du registre d'approximations successives 4 et la troisième porte OU-EXCLUSIVE est alimentée par la sortie de la deuxième porte et par le bit de troisième plus grand poids du registre d'approximations successives 4.

La sortie de la première porte donne le bit de plus grand poids en code Gray et détermine la polarité du signal SIN. La sortie de la seconde porte donne le bit de second plus grand poids en code Gray et détermine la polarité du signal COS. Enfin la sortie de la troisième porte donne le bit de troisième plus grand poids en code Gray qui détermine si la valeur absolue du signal SIN est plus grande ou plus petite que la valeur absolue du signal COS.

Pour la détermination des deux premiers bits de plus grand poids en code Gray le bit de troisième plus grand poids binaire du registre d'approximations successives 4 qui sélectionne dans la PROM 11 le réseau tg ou cotg est à l'état I ainsi que tous les bits suivants. Le signal présenté à l'entrée REF du convertisseur 5 (figure 7) est donc multiplié par 0 analogiquement et le comparateur 3 compare le signal présenté à l'entrée SIG à ce 0 pour connaître sa polarité. C'est le troisième bit de plus grand poids en code Gray qui dirige les signaux SIN et COS soit vers l'entrée REF soit vers l'entrée SIG pour les quadrants Gray impairs et l'inverse pour les quadrants Gray pairs.

Ainsi donc, dans cette première phase on détermine si l'angle correspondant aux signaux SIN et COS se trouve dans un quadrant Gray pair ou impair.

La seconde phase de la conversion permet la détermination définitive du quadrant Gray, c'est-à-dire le troisième bit de plus grand poids Gray, dans lequel l'approximation successive trigonométrique classique va avoir lieu. Le troisième bit binaire de plus grand poids étant à l'état 0, le signal qui est délivré à l'entrée REF du convertisseur 5 est maintenant multiplié par I dans toutes les quatre positions. On compare donc les signaux délivrés aux entrées SIG et REF du convertisseur 5 à leur vraie amplitude pour déterminer lequel est en dessus de la valeur

$\frac{1}{\sqrt{2}}$ fois l'amplitude d'entrée ; l'autre étant en dessous. La décision du comparateur 3 détermine le quadrant Gray et par conséquent l'octant binaire où la troisième phase de la conversion va se dérouler. Les figures 8 et 9 visualisent les opérations effectuées sur les trois bits de plus grand poids des signaux SIN et COS permettant la détermination de l'octant binaire.

La troisième phase de la conversion détermine les bits binaires du quatrième de plus grand poids au dernier qui correspondent à la valeur numérique de l'angle à l'intérieur de l'octant binaire déterminé par les deux premieres phases de la conversion.

Pour cette troisième phase de la conversion les entrées REF et SIG du convertisseur 5 ne varient plus et l'on a :

$$V\,max > \quad REF > V\,max\,/\sqrt{2} \qquad \left.\begin{array}{l} \\ \end{array}\right\} \quad octants$$
$$0 > \quad SIG >- V\,max\,/\sqrt{2} \qquad \left.\begin{array}{l} \\ \end{array}\right\} \quad impairs$$

$$-V\,max \qquad > REF \quad - \quad max \qquad \left.\begin{array}{l} \\ \end{array}\right\} \quad octants$$
$$-V\,max\,/\sqrt{2} > SIG \qquad 0 \qquad \left.\begin{array}{l} \\ \end{array}\right\} \quad pairs$$

et les approximations successives du registre 4 résolvent les équations :

[REF x tg $\frac{\pi}{4}$ x - SIG]→ 0 dans les octants impairs

[SIG-REF x cotg $\frac{\pi}{4}$ (x + 1)]→ 0 dans les octants pairs.

Dès lors, le bus 13 délivre au circuit de sortie les N bits définissant la valeur numérisée de l'angle à mesurer défini par les signaux SIN et COS, valeur numérisée de l'angle qui peut être utilisée pour toute utilisation désirée.

L'utilisation d'un convertisseur numérique-analogique à double chargement 5 est conditionnée par l'organisation de la mémoire morte 11 qui est une PROM bipolaire ou CMOS organisée avec des sorties en octets (huit bits en parallèle). Ceci oblige à utiliser un convertisseur 5 à double chargement et à doubler le nombre d'adresses dans la mémoire 11.

La courbe tangente $\frac{\pi}{4}$ X n'a pas une non-linéaritée très prononcée entre 0 < x < 1, avec une pente de $\frac{\pi}{4}$ = 0,785 au départ et $\frac{\pi}{2}$ = 1,570 à pleine échelle. Avec A bits d'adresse, il est donc possible de générer la correction avec (A + 1) bits de données. En sachant que les premiers bits de plus grand poids et les deuxièmes bits de plus grand poids binaires ne passent pas dans la PROM, et que un bit d'adresse différencie les deux octants correspondant à une seule valeur de la fonction tg/cotg, nous avons une capacité de PROM de (N-2 + 1) = (N-1) adresses de 8 bits ou N est la résolution du convertisseur.

La lecture alternée des deux octets constituant une valeur de la fonction est faite par l'horloge qui cadence le registre et qui charge les octets supérieurs et inférieurs de la PROM dans les registres correspondants du convertisseur numérique-analogique. Après chargement, la sortie analogique du convertisseur numérique-analogique est activée pour permettre la décision du comparateur.

Le poids du bit de plus petit poids dépend de la résolution du convertisseur mais aussi de la position. Il est maximum autour des points cardinaux et atténué dans le rapport 1/√2 autour des points intercardinaux du fait de la correction tg/cotg.

| Résolution N bits | Bit de PPP à 0° |
|---|---|
| 12 | 15,34 m v |
| 14 | 3,84 m v |
| 16 | 0,96 m v |
| pour des signaux v max = 10 volts. | |

Ces niveaux sont nettement plus élevés que ceux d'un convertisseur linéaire équivalent de même résolution. Pour un convertisseur analogique-numérique binaire bipolaire de 14 bits par exemple le bit de plus petit poids est :

$$\frac{20.000 \ m\sqrt{\ }}{2^{14}} = 1,22 \ m\sqrt{\ }$$

il est donc possible de construire ce convertisseur avec des éléments en particulier les échantillonneurs-bloqueurs et le comparateur dont le décalage de tension d'entrée et le "piédestal" au moment du blocage sont relativement élevés.

Il est évident que dans une variante du convertisseur analogique-numérique le convertisseur numérique-analogique à double chargement 5 pourrait être non-linéaire de caractéristiques tangente ou cotangente dont les entrées numériques sont contrôlées par le bit binaire d'octant à travers un niveau inverseur de portes OU-EXCLUSIF.


## Revendications

1. Procédé de numérisation de la valeur d'un angle défini par ses coordonnées trigonométriques sinus et cosinus selon lequel :

a. on procède à un échantillonnage au rythme d'une fréquence porteuse de la valeur des deux signaux trigonométiques aux sommets positifs et négatifs de la porteuse et bloque temporairement les valeurs instantanées de ces signaux,

b. on détermine à partir des signaux sinus et cosinus stockés l'angle correspondant par une conversion analogique-numérique par approximations successives, réalisée par un seul convertisseur numérique-analogique en rétroaction et un registre d'approximations successives à N bits,

c. lors d'une première phase de la conversion on détermine les deux premiers bits de cet angle numérisé par la détection des polarités du signal sinus et du signal cosinus,

d. lors d'une seconde phase de cette conversion on détermine le troisième bit de cet angle numérisé par comparaison des valeurs absolues des signaux sinus et cosinus,

e. on utilise la plus grande valeur de cette comparaison comme référence du convertisseur digital-numérique et la plus petite valeur de cette comparaison comme signal d'entrée de ce convertisseur,

f. on détermine à l'aide du troisième bit binaire de l'angle numérisé la fonction non linéaire, tangente ou cotangente, utilisée en rétroaction pour la déterminaison des quatrièmes à énièmes bits,

g. on transforme les trois premiers bits binaires purs obtenus par les première et seconde phases de comparaison en code Gray avec inversion du bit de plus grand poids à chaque demi période de la fréquence porteuse,

h. on détermine, à l'aide des trois premiers bits binaires purs de la conversion de l'angle numérisé après les avoir transformés en code Gray, l'octant de l'angle à déterminer,

i. lors d'une troisième phase de la conversion on détermine les quatrièmes à énièmes bits de l'angle numérisé à mesurer par une conversion non linéaire pondérée par la fonction trigonométrique définie par le troisième bit de la conversion,

j. on génère en fonction des sommets positifs ou négatifs de la fréquence porteuse les mots binaires, (tous 0) ou (tous 1), nécessaires dans les deux premières phases de conversion pour la détermination de la polarité des bits et dans la troisième phase de la conversion pour la détermination de la fonction trigonométrique utilisée pour la détermination des quatrièmes à énièmes bits correspondant à la numérisation de l'angle mesuré.

2. Procédé selon la revendication 1, caractérisé par le fait que les fonctions non linéaires tangente et cotangente sont stockées dans une mémoire morte, branchée entre le registre d'approximations successives et le convertisseur numérique-analogique.

3. Procédé selon la revendication 1, caractérisé par le fait que le convertisseur numérique-analogique est non linéaire de caractéristique tangente ou cotangente et qu'il est alimenté directement par les sorties digitales du registre d'approximations successives.

4. Procédé selon l'une des revendications précédentes, caractérisé par le fait qu'on transforme en code Gray les trois premiers bits binaires du registre d'approximations successives pour déterminer à l'aide des deux premiers la polarité des signaux SIN et COS stockés permettant de définir le quadrant Gray de l'angle et le troisième bit en code Gray définissant l'octant trigonométrique dans lequel se trouve l'angle.

5. Dispositif pour la mise en oeuvre du procédé selon l'une des revendications précédentes, caractérisé par le fait qu'il comporte un circuit d'entrée, formé d'amplifications de gain +1 et -1 pour chacun des signaux SIN et COS représentatifs d'un angle, alimentant un multiplexeur délivrant ces signaux à un double commutateur ; une boucle de conversion comportant un dispositif de conversion numérique-analogique à double chargement dont les sorties alimentent les entrées d'un comparateur dont la sortie pilote un registre d'approximations successives alimenté par une tension de référence et un signal d'horloge ; les trois sorties binaires de plus grand poids de ce registre alimentent un transcodeur binaire / code Gray pilotant le multiplexeur par ses deux bits Gray de plus grand poids et le double commutateur par le bit Gray de troisième plus grand poids pour définir quel signal SIN ou COS est appliqué à l'entrée REF ou SIG et inversement du dispositif de conversion ; le troisième bit binaire du registre à approximations successives définissant la fonction non linéaire tangente ou cotangente du dispositif de conversion qui devra traiter les quatrièmes à énièmes bits du registre à approximations successives par le dispositif de conversion ainsi qu'un circuit de sorties délivrant les N bits binaires du registre à approximations successives une fois la conversion terminée.

6. Dispositif selon la revendication 5, caractérisé par le fait que le dispositif de conversion est constitué par un convertisseur numérique-analogique à double chargement non linéaire.

7. Dispositif selon la revendication 5, caractérisé par le fait que le dispositif de conversion est constitué par un convertisseur numérique-analogique à double entrées linéaires et une mémoire morte mémorisant les fonctions non linéaires, mémoire branchée entre le registre à approximations successives et le convertisseur numérique-analogique.

FIG. 1

FIG. 2

| OCTANT | SIGNE $(S_1 - S_3)$ | SIGNE $(S_2 - S_4)$ | $|E(S_1-S_3)| \gtrless |(S_2-S_4)|$ |
|--------|--------|--------|--------|
| I | + | + | $|E(S_1-S_3)| < |(S_2-S_4)|$ |
| II | + | + | $|E(S_1-S_3)| > |(S_2-S_4)|$ |
| III | + | − | $|E(S_1-S_3)| > |(S_2-S_4)|$ |
| IV | + | − | $|E(S_1-S_3)| < |(S_2-S_4)|$ |
| V | − | − | $|E(S_1-S_3)| < |(S_2-S_4)|$ |
| VI | − | − | $|E(S_1-S_3)| > |(S_2-S_4)|$ |
| VII | − | + | $|E(S_1-S_3)| > |(S_2-S_4)|$ |
| VIII | − | + | $|E(S_1-S_3)| < |(S_2-S_4)|$ |

## FIG. 3

## FIG. 4

# FIG. 5

# FIG. 6

FIG. 7

SIN

COS

½ PERIODE

2 PGPG

1 PGPG

3 PGPG

SIG

REF

DEPART
CONVERSION

HORLOGE
SYNCHRONE

3 PGPB
2 PGPB
1 PGPB

DECISION
ACCEPTÉ/REJETÉ

FIG. 8

| OCT | I | II | III | IV | V | VI | VII | VIII |
|---|---|---|---|---|---|---|---|---|
| RAS | 0 0 0 | 0 0 1 | 0 1 0 | 0 1 1 | 1 0 0 | 1 0 1 | 1 1 0 | 1 1 1 |
| SEL | 0 0 0 | 0 0 1 | 0 1 1 | 0 1 0 | 1 1 0 | 1 1 1 | 1 0 1 | 1 0 0 |

SIG ——
REF -----

$1$
$1/\sqrt{2}$
$0$
$1/\sqrt{2}$
$1$

SIG
REF

PROGRAMME MEMOIRE

TOUS I  TG  TOUS 0  COTG  TOUS I  TG  TOUS 0  COTG  TOUS I  TG  TOUS 0  COTG  TOUS I  TG  TOUS 0  COTG

| REF | ⊕ COS | ⊖ SIN | ⊕ SIN | ⊕ COS | ⊖ COS | ⊕ SIN | ⊖ SIN | ⊖ COS |
| SIG | ⊖ SIN | ⊕ COS | ⊕ COS | ⊕ SIN | ⊕ SIN | ⊖ COS | ⊖ COS | ⊖ SIN |

FIG. 9  SIG ——— REF -----

FIG. 10